# DEMANDE DE BREVET EUROPEEN

(11) **EP 1 258 985 A1**
(43) Date de publication de la demande: **20.11.2002**
(21) Numéro de dépôt: 02368050.7
(22) Date de dépôt: 13.05.2002
(51) Int. Cl.: H03F 3/45, H03F 3/30

(54) **Amplificateur différentiel large bande comportant un dispositif compensant la perte de gain en haute fréquence**

(30) Priorité: 14.05.2001 FR 0106298
(71) Demandeur: STMicroelectronics S.A., 92120 Montrouge (FR)
(72) Inventeur: Renous, Claude, 38100 Grenoble (FR); Van-Zanten, Francois, 38240 Meylan (FR)
(74) Mandataire: Schuffenecker, Thierry

(57) **Abrégé**

Amplificateur différentiel large-bande comportant un premier étage différentiel suivi d'un étage de Miller permettant d'accroître le gain en boucle ouverte. L'étage de Miller comporte une source de courant dans laquelle un réseau résistif-capacitif provoquer une réinjection d'une partie du signal de sortie de l'étage de MILLER, à haute fréquence, de manière à déplacer, dans ces fréquences, le point de polarisation de la source de courant et ainsi, accroître sensiblement le gain de l'étage de Miller vers cette valeur extrème de la fréquence.

## Description

### Domaine technique de l'invention

La présente invention concerne les circuits amplificateurs à semi-conducteurs et notamment un circuit amplificateur différentiel doté d'un dispositif de compensation de gain à haute fréquence.

### Etat de la technique

Les amplificateurs différentiels connaissent une large application dans le domaine des télécommunications. Ils permettent en effet le traitement des signaux véhiculant la voix et, plus généralement les données. La structure différentielle est particulièrement privilégiée puisque celle-ci permet, d'une manière générale, de réduire les harmoniques et non linéarités d'ordre 2 dans le bruit de distorsion. Elle assure en outre une plus grande immunité par rapport aux perturbations en mode commun, telles que celles affectant les circuits d'alimentation des circuits électroniques.

Pour ces raisons les amplificateurs différentiels sont particulièrement utilisés dans tous les réseaux de transports de données des réseaux filiaires (*Wide Area Network*) tels qu'on les rencontre pour les réseaux de type *Asynchronous Transfer Mode* (A.T.M.) ou encore *Asynchronous Digital Subscriber Line* (A.D.S.L.) et leurs principaux dérivés H.D.S.L (que l'on désigne communément sous le vocable générique de X.D.S.L.).

Dans ce type de réseaux, la linéarité des amplificateurs différentiels est devenue un facteur décisif et ce, d'autant plus que ceux-ci seront amenés à fonctionner dans une large gamme de fréquence, par exemple entre 30 Khz à 10 Mhz. Il est à noter, en outre, que dans les applications de type H.S.D.L. ou V.D.S.L. les signaux qui véhiculent les données sont de grande amplitude, de l'ordre du volt, et que par conséquent les amplificateurs doivent pouvoir traiter ces grands signaux avec une linéarité satisfaisante. A cet effet, il est essentiel que les structures d'amplificateur présentent une gain en boucle ouverte élevé dans toute la gamme de fréquences considérées, et non pas seulement dans une portion étroite de la bande. Ainsi, si on arrive à maintenir un gain élevé jusque vers 10 Mhz par exemple, on pourra bénéficier d'un fort taux de contre-réaction jusque vers cette valeur extrême et, par suite, une linéarité satisfaisante pour les applications considérées.

Il est donc souhaitable de pouvoir disposer d'une structure d'amplificateur différentiel large bande, simple et peu onéreuse et qui assure un gain élevé dans les valeurs extrêmes de la bande de fréquence.

### Exposé de l'invention

La présente invention a pour but de proposer une structure d'amplificateur différentiel large bande qui est dotée d'un dispositif de compensation de gain à haute fréquence, permettant de maintenir le gain en boucle ouverte jusqu'aux valeurs les plus élevées de la bande de fréquence.

Un autre but de la présente invention consiste à proposer un dispositif d'amplificateur différentiel comportant un haut degré de linéarité, qui puisse être parfaitement intégré dans un circuit intégré, et utilisant notamment des composants de type MOS de la technologie bi-CMOS.

C'est un autre but de la présente invention que de fournir une structure d'amplificateur différentiel parfaitement compatible aux exigences des réseaux de télécommunications, et notamment les liaisons de type A.S.D. L. ou H.S.D.L.

L'invention réalise ces buts au moyen d'un circuit amplificateur différentiel destiné à fonctionner dans une bande de fréquence disposant d'une première et seconde électrodes d'entrées (E1, E2) ainsi qu'une première et seconde électrodes de sortie (O1, O2). Le circuit comporte
- un premier étage composé d'un premier et second transistor de même polarité et montés en amplificateur différentiel, lesdits premier et second transistor étant respectivement alimentés par une première et une seconde source de courant miroir dont le courant est commandé par un circuit de contrôle gérant la tension de mode commun ;
- un second étage de gain de Miller composé d'un troisième et quatrième transistor de type inverse auxdits premier et second transistors, dont les entrées reçoivent les signaux de sortie du premier étage, et respectivement alimentés par une troisième et une quatrième sources de courant, lesdites troisième et quatrième sources de courant étant commandées par une tension de polarisation (Vgs) dans laquelle se trouve réinjectée à haute fréquence, via un circuit résistif-capacitif, une partie du signal de sortie (O1 , O2) de manière à accroître sensiblement le gain dudit second étage vers l'extrémité droite de ladite bande de fréquence.
   Dans un mode de réalisation préféré, les premier et second transistors sont des transistors de type NMOS et les troisième et quatrième transistors sont des transistors de type PMOS qui sont montés en source commune. Les drains de ces transistors PMOS sont respectivement connectées aux sorties O1 et O2 et présentent des grilles sont respectivement connectées de manière à recevoir le signal de sortie correspondant dudit premier étage.
   Plus particulierement, les sources de courant de l'étage de gain de type Miller, qui sont compensées en fréquence, comportent
- un premier condensateur présentant une première électrode connectée à la dite première électrode de sortie (O1) et une seconde électrode ;
- un second condensateur présentant une première électrode connectée à ladite seconde électrode de sortie (O2) et une seconde électrode ;
- une première résistance présentant une première électrode connectée à la seconde électrode dudit second condensateur;
- une seconde résistance présentant une première électrode connectée à la seconde électrode dudit premier condensateur ; lesdites premières et secondes résistances présentant une seconde électrode commune qui sont toutes les deux connectées à une cinquième source de courant;
- un cinquième transistor, par exemple de type NMOS, comportant une source, un drain et une grille qui sont respectivement connectées à la masse, à ladite première électrode de sortie O1, et à première électrode de ladite première résistance, et dont la grille est également connectée à la seconde électrode dudit second condensateur;
- un sixième transistor, par exemple de type NMOS, comportant une source, un drain et une grille, qui sont respectivement connectées à la masse, à ladite seconde électrode de sortie O2, et à la première électrode de ladite seconde résistance; la grille étant en outre connectée à la seconde électrode dudit premier condensateur;
- un septième transistor, par exemple de type NMOS, comportant une source connectée à la masse, un drain et une grille connectées auxdites secondes électrodes des première et seconde résistance;
de telles manière que le circuit passif composé desdits premier et second condensateur et desdits première et seconde résistance provoque, dans les valeurs élevées de fréquence, une réinjection des signaux de sorties dans les tensions de grille de manière à maintenir le gain de l'étage.

Dans un mode réalisation particulier, l'amplificateur peut être doté d'un étage cascode ou suiveur comportant, par exemple, des transistors bipolaires.

L'invention est particulièrement adaptée à la conception d'amplificateur large bande utilisée en télécommunication filiaires, et notamment les réseaux de type Asynchronous Digital Line Subscriber (A.D.S.L), et leurs dérivés.

### Description des dessins

La figure 1 illustre une structure classique d'amplificateur comportant une étage différentiel suivi d'un étage de gain de Miller.

La figure 2 illustre un mode de réalisation de l'invention dans lequel l'étage de Miller est associée à une source de courant compensée en haute fréquence.

La figure 3 illustre un mode particulier de réalisation d'une structure complète, comportant un étage de gestion du mode commun.

La figure 4 montre un autre mode de réalisation comportant un circuit cascode intercalé entre l'étage différentiel et l'étage de gain de Miller.

### Description d'un mode de réalisation préféré

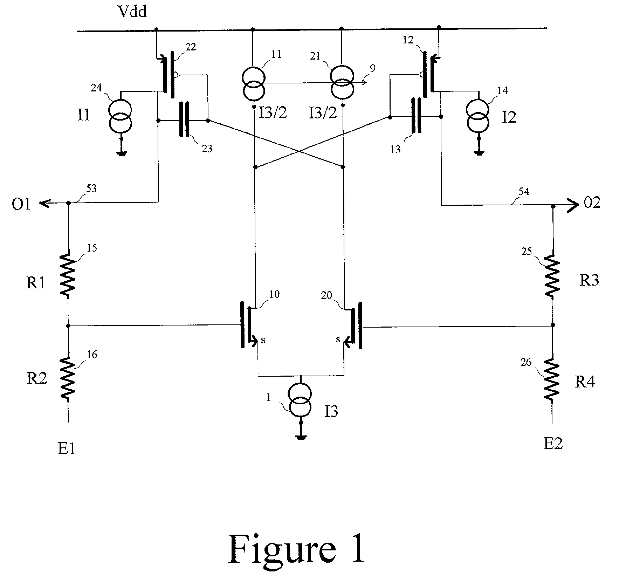

La figure 1 illustre une structure classique d'amplificateur différentiel qui comporte un premier transistor 10 et un second transistor 20, par exemple de type NMOS, formant une paire différentielle. Bien que le mode de réalisation préféré décrit plus particulièrement l'emploi de transistors de type NMOS il est clair que l'homme du métier pourra adapter l'enseignement de l'invention à une architecture comportant des transistors de type opposé, c'est à dire PMOS. L'amplificateur est alimenté au moyen d'une source d'alimentation délivrant une tension V_{dd} . Les transistors 10 et 20 présentent une électrode de source qui est connectée d'une manière commune à une source de courant 1 (I3) dont l'autre extrémité est connectée à un potentiel de référence, en général la masse. Chaque transistor de la paire différentielle 10-20 est alimenté via son électrode de drain par une source de courant 11 et 21, lesquelles sont montées en miroir de courant commandé par un étage de gestion du mode commun (non représenté).

La paire différentielle composée des premiers et second transistors 10 et 20 sert de premier étage qui attaque un second étage de gain de type Miller. Ce second étage comporte un troisième et quatrième transistor 12 et 22 respectivement, par exemple de type PMOS qui sont montés en source commune. Plus précisément, le drain du premier transistor 10 (resp. le second transistor 20) est connecté à la grille du troisième transistor 12 (resp. le quatrième transistor 22), dont la source est connectée à la borne d'alimentation V_{dd}. Le drain du troisième transistor 12 (resp. quatrième transistor 22) est connecté à une source de courant 14 (resp. 24), elle-même connectée, à son autre extrémité à la masse. Le drain du troisième transistor 12 (resp. quatrième transistor 22) est également connecté à l'électrode 54 de sortie 02 (resp. électrode 53 de sortie 01) de l'amplificateur différentiel. Un condensateur 13 (resp. 23) vient compléter la structure de Miller et se connecte entre le drain et la source du troisième transistor 12 (resp. quatrième transistor 22). L'étage de Miller est conçu pour fonctionner en classe A et les sources de courant 14 et 24 seront donc dimensionnées en conséquence, de manière à pouvoir écouler le courant appelée dans la charge de l'amplificateur.

L'association de la paire différentielle 10-20 et des étages de gain de Miller 12-22 permet d'assurer à l'ensemble de l'amplificateur un gain en boucle ouverte particulièrement élevé et de fixer en outre son produit gain-bande. Des résistances de contre-reaction 15 (R1), 16 (R2), 25 (R3) et 26 (R4) sont utilisés pour fixer le gain en boucle fermée à la valeur souhaitée, laquelle est R1/R2 = R3/R4. Plus précisément, comme on le voit sur la figure 1, l'ensemble 15 et 16 constitue un pont de résistance dont les extrémités sont respectivement connectées à l'électrode de sortie O1 et l'électrode d'entrée E1 de l'amplificateur différentiel, et dont le point milieu est connecté à la grille du transistor 10. De la même manière, les résistances 25 et 26 constituent un pont dont les extrémités sont respectivement connectées à l'électrode de sortie O2 et l'électrode d'entrée E2, et dont le point milieu est connecté à la grille du transistor 20.

On constate dans ce type d'amplificateur connu une perte sensible de gain en boucle ouverte lorsque la fréquence s'approche de la valeur extrème droite de la bande de fréquence recherchée.

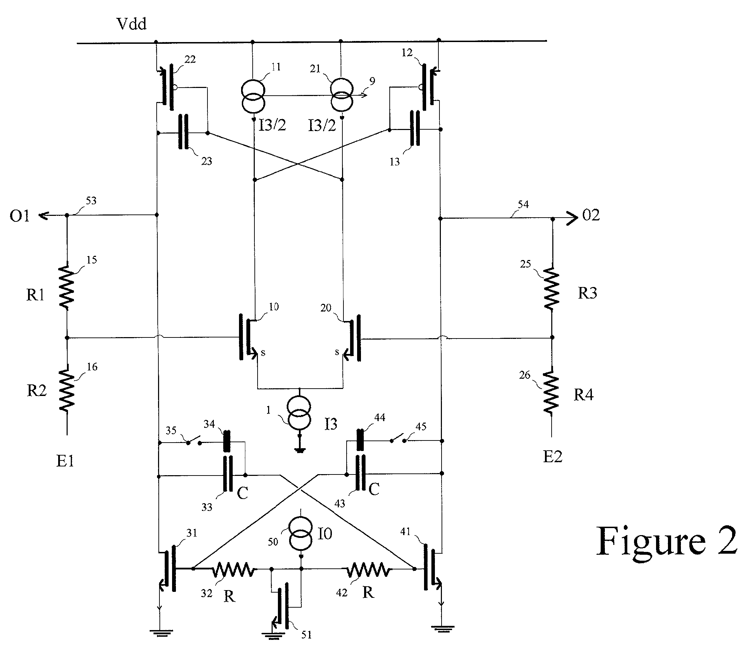

La figure 2 montre de quelle manière on peut considérablement améliorer la situation et compenser la perte de gain en boucle ouverte de l'amplificateur différentiel. A cet effet on substitue aux sources de courant 14 et 23 une source de courant dotée d'un circuit de compensation de fréquence agissant sur la partie élevée de la bande de fréquence de l'amplificateur différentiel.

Plus spécialement, le circuit de compensation de fréquence comporte un cinquième et sixième transistor , respectivement 31 et 41 de type NMOS, qui sont montés en miroir de courant par rapport à un septième transistor 51 également de type NMOS. Les cinquième, sixième et septième transistors 31, 41 et 51 ont tous leur source connectée à la masse. Le drain du cinquième transistor 31 est connecté à l'électrode 53 de sortie O1 et, pareillement, le drain du sixième transistor est connecté à l'électrode 54 de sortie O2. Le drain et la grille du septième transistor 51 sont connectés à une source 50 de courant I0 dont l'autre extrémité est connectée à la tension d'alimentation V_{dd}. Le drain et la grille du septième transistor 51 est également connecté à une résistance 32 et une résistance 42 présentant chacune une autre électrode qui est respectivement connectées à la grille du transistor 31 et à la grille du transistor 41. Un condensateur 33 est intercalé entre l'électrode 53 de sortie O1 et la grille du transistor 41 et, de l'autre côté, un autre condensateur 43 est intercalé entre l'électrode 54 de sortie O2 et la grille du transistor 31.

Comme on le voit sur la figure 2, les cinquième, sixième et septième transistors 32, 42 et 51 sont montés en miroir de courant permettant l'alimentation des troisième et quatrième transistors 13 et 14 de l'étage de Miller. Du fait de la présence de deux condensateurs 33 et 43, une partie du signal de sortie 01 (resp. O2) se trouve réinjectée sur le potentiel de grille du transistor 41 (resp. du transistor 51). Ce phénomène entraîne un déplacement du point de polarisation des transistors 31 et 41 et, par suite, un afflux de courant dans les sources de l'étage de Miller et un accroissement correspondant du gain de l'étage. Si l'on fixe judicieusement les valeurs des résistances 32-42 et celles des condensateurs 33-43 de manière à obtenir une fréquence de coupure qui s'insère dans la partie droite de la bande de fréquence recherchée, on pourra par cette construction compenser la perte naturelle de gain en boucle ouverte de l'amplificateur lorsque l'on fait travailler l'amplificateur dans l'extrémité droite de la bande de fréquence.

Ainsi le circuit de compensation permet de compenser la perte de gain que l'on constate normalement dans les fréquences les plus élevées.

Il est clair que le positionnement de la fréquence de coupure du circuit passif résistif-capacitif 32-33 et 42-43 est particulièrement décisif. Il faudra pouvoir effectuer un réglage fin du produit RC des valeurs de résistances et des valeurs de capacité. Dans un mode de réalisation particulier, l'amplificateur des doté d'une dispositif dit de *RC-tuning* qui réalise, lors du démarrage dans une phase d'initialisation, une mesure précise de la valeur du produit RC des résistances 32-42 et des condensateurs 33-43. A cet effet, des condensateurs additionnels, par exemple les condensateurs 34 et 44 sur la figure 2, peuvent être branchés en parallèle sur les condensateurs 33 et 43 au moyen de commutateurs électriques, 35 et 45 respectivement. Un circuit de commande (non représenté) comporte une source de courant de précision, laquelle alimente un circuit oscillateur formé par les résistances 32-42 et les condensateurs 33-43. Le circuit de commande comporte également des moyens de mesure de la fréquence d'oscillation du circuit oscillateur formé par des résistances et ces capacités. En fonction de la mesure effectué, le circuit de commande détermine les signaux de commande à appliquer aux commutateurs 35 et 45 durant la phase opérationnelle postérieure à la phse d'initialisation, de manière à assurer un réglage fin de la compensation du gain apportée par les transistors 31 et 41 durant cette phase opérationnelle .

Le circuit de compensation qui vient d'être décrit s'adapte à toutes les formes connues de structures différentielles. On illustrera cette grande flexibilité à l'aide de deux modes de réalisation particulier : un mode de réalisation comportant un étage de gestion de mode commun, et un autre mode de réalisation comportant un circuit cascode.

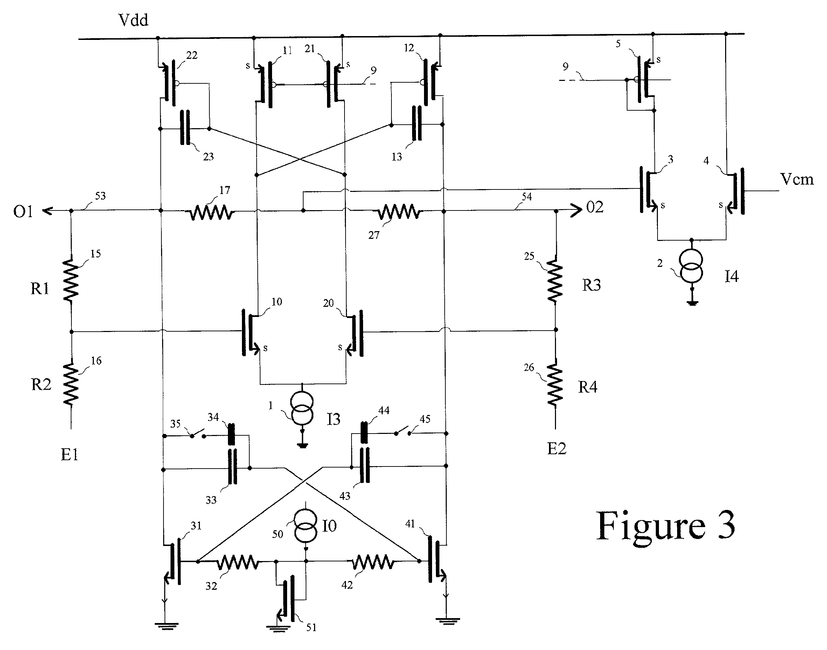

La figure 3 développe le circuit amplificateur doté, outre du système de compensation de la figure 2, d'un étage de gestion de mode commun. Dans cette structure, les sources de courant 11 et 12 sont réalisées par des transistors de type PMOS qui sont commandés par un étage de gestion du mode commun qui comporte une seconde paire différentielle associée à une source de courant 2 (I4) et un transistor 5 de type PMOS. Plus particulièrement, la seconde paire différentielle comporte deux transistors 3 et 4 dont les sources sont connectées à une source de courant 2 (I4) présentant une autre extrémité connectée à la masse. Le drain des transistors 3 et 4 est respectivement connecté au drain du transistor 5 et à la borne d'alimentation V_{dd}. La grille du transistor 3 est connectée au point milieu d'un pont résistif, comportant deux résistances 17 et 27 de valeur généralement similaires, dont les extrémités sont connectées aux bornes de sorties O1 et O2 de l'amplificateur différentiel. Le pont résistif 17-27 est utilisé pour permettre l'obtention, en son point milieu, d'un potentiel représentatif de la valeur de mode commun des sorties O1 et O2 de l'amplificateur différentiel. La grille du transistor 4 reçoit une tension de consigne - V_{cm} - qui est utilisée pour régler le niveau de polarisation de l'étage en mode commun et que l'on fixe généralement à V_{dd}/2 de manière à obtenir une excursion maximale du signal de sortie sur les bornes 53 (O1) et 54 (O2).

Les électrodes de grilles des transistors 5 , 11 et 12 sont toutes connectées ensemble et la grille du transistor 5 est connecté au drain de ce même transistor, assurant ainsi son fonctionnement dans la zone quadratique de sa caractéristique I (V_{gs}). Les transistors sont ainsi montés en miroir de courant et sont parcourus par un même courant de drain puisque, étant sensiblement identiques, ils sont soumis aux mêmes variations de la tension grille-source V_{gs}.

Comme on le voit sur la figure 3, le circuit de gestion de la tension de mode commun permet de fixer les potentiels en mode commun autour de la valeur de consigne, à savoir V_{cm} = V_{dd} /2. En effet, on constate que si le potentiel de l'une des sorties venait à s'élever pour une raison quelconque, par exemple un accroissement de la température du circuit, cette élévation se répercuterait au niveau du point milieu du pont résistif 17-27, entraînant ainsi une élévation correspondante de la tension de grille du transistor 3. Ce dernier serait alors parcouru par un afflux de courant puisque la tension de grille du transistor complémentaire 4 resterait fixée à la valeur inchangée de la consigne Vcm. Les courants dans les transistors 11 et 21 seraient alors modifiés provoquant ainsi un retour de la tension de sortie vers la valeur de consigne.

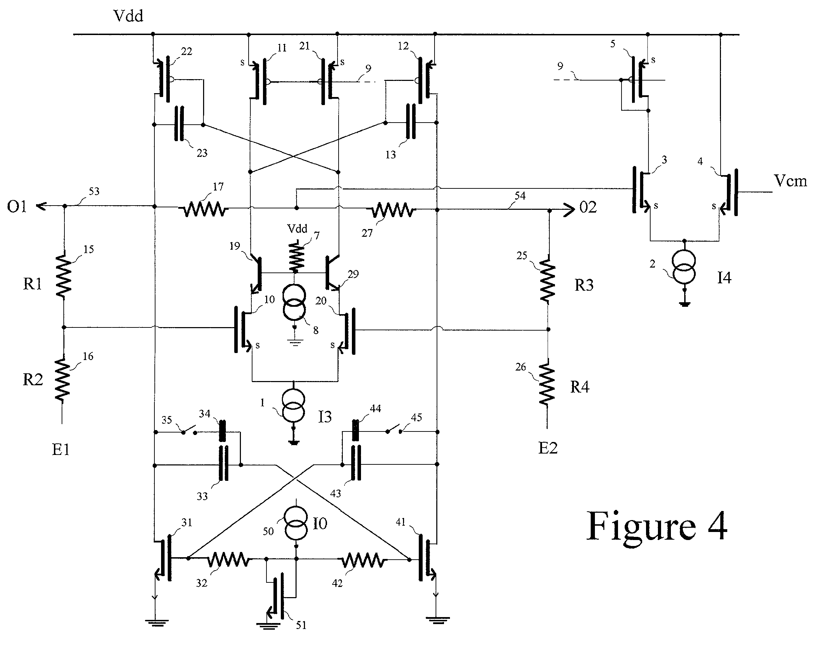

Dans un autre mode de réalisation qui est illustrée dans la figure 4, l'amplificateur pourra être doté d'un suiveur adaptateur d'impédance entre la paire différentielle 10-20 et l'étage de Miller. Dans ce mode de réalisation l'électrode de drain du transistor 10 n'est pas directement connectée à l'électrode de drain du transistor 11, mais un transistor bipolaire de type NPN vient s'intercaler entre les deux transistors 10 et 11. Plus précisément, l'émetteur et le collecteur du transistor 19 sont respectivement connectés au drain du transistor 10 et au drain du transistor 11. De la même manière, un transistor bipolaire 29, également de type NPN, vient s'intercaler entre le transistor 20 et le transistor 21. Plus précisément, l'émetteur et le collecteur du transistor 29 sont respectivement connectés au drain du transistor NMOS 20 et au drain du transistor 21. Les bases des deux transistors bipolaires sont connectées à une résistance 7 ramenant au potentiel d'alimentation V_{dd} et à une source de courant 8 dont l'autre extrémité est connectée à la masse. Le circuit cascode présente l'avantage, comme cela est connu de l'homme du métier, de présenter une impédance importante au premier étage constituée par la paire de transistors 10 et 20 de manière à accroître encore le gain en boucle ouverte de l'amplificateur.

Le circuit de compensation de fréquence qui vient d'être décrit peut donc être intégré à toutes sortes de circuits amplificateurs, et se révèle parfaitement adapté à à la technologie bi-CMOS. Il est à noter, en outre, que l'homme du métier pourra très facilement adapter la structure de la figure 3 à l'emploi d'un circuit cascode composé de transistors de type NMOS et non plus simplement bipolaires.

## Revendications

1. Circuit amplificateur différentiel destiné à fonctionner dans une bande de fréquence disposant d'une première et seconde électrodes d'entrées (E1, E2) ainsi qu'une première et seconde électrodes de sortie (O1, O2) ; le circuit comportant
- un premier étage composé d'un premier et second transistor (10, 20) de même polarité et montés en amplificateur différentiel, lesdits premier et second transistor étant respectivement alimentés par une première et une seconde source de courant miroir (11, 21) dont le courant est commandé par un circuit de contrôle gérant le mode commun (2, 3, 4, 5) ;
- un second étage de gain de Miller composé d'un troisième et quatrième transistor (12, 22), de type inverse auxdits premier et second transistors (10, 20), dont les entrées reçoivent les signaux de sortie du premier étage, et respectivement alimentés par une troisième et une quatrième sources de courant, lesdites troisième et quatrième sources de courant étant commandées par une tension de polarisation (Vgs) dans laquelle se trouve réinjectée à haute fréquence, via un circuit résistif-capacitif (32, 42, 33, 43) , une partie du signal de sortie (O1 , O2) de manière à déplacer le point de polarisation des troisième et quatrième sources de courant et ainsi accroître sensiblement le gain dudit second étage vers l'extrémité droite de ladite bande de fréquence.

2. Circuit amplificateur différentiel selon la revendication 1 **caractérisé en ce que** lesdits premier et second transistor sont des transistors de type NMOS et **en ce que** lesdits troisième et quatrième transistors sont des transistors de type PMOS montés en source commune et dont les drains sont respectivement connectées aux dites sorties O1 et O2 et présentant des grilles sont respectivement connectées de manière à recevoir le signal de sortie correspondant dudit premier étage.

3. Circuit amplificateur différentiel selon la revendication 1 **caractérisé en ce que** les troisième et quatrième source de courant comportent :
- un premier condensateur (33) présentant une première électrode connectée à la dite première électrode de sortie (O1) et une seconde électrode ;
- un second condensateur (43) présentant une première électrode connectée à ladite seconde électrode de sortie (O2) et une seconde électrode ;
- une première résistance (32) présentant une première électrode connectée à la seconde électrode dudit second condensateur (43) ;
- une seconde résistance (42) présentant une première électrode connectée à la seconde électrode dudit premier condensateur ; lesdites premières et secondes résistances (32, 42) présentant une seconde électrode commune qui sont toutes les deux connectées à une cinquième source de courant (50) ;
- un cinquième transistor (31), par exemple de type NMOS, comportant une source, un drain et une grille qui sont respectivement connectées à la masse, à ladite première électrode de sortie O1, et à première électrode de ladite première résistance (32), et dont la grille est également connectée à la seconde électrode dudit second condensateur (42) ;
- un sixième transistor (41), par exemple de type NMOS, comportant une source, un drain et une grille, qui sont respectivement connectées à la masse, à ladite seconde électrode de sortie O2, et à la première électrode de ladite seconde résistance (42) ; la grille étant en outre connectée à la seconde électrode dudit premier condensateur (33);
- un septième transistor (51), par exemple de type NMOS, comportant une source connectée à la masse, un drain et une grille connectées auxdites secondes électrodes des première et seconde résistance (32, 42) ;
de telles manière que le circuit passif composé desdits premier et second condensateur et desdits première et seconde résistance provoque, dans les valeurs élevées de fréquence, une réinjection des signaux de sorties dans les tensions de grille de manière à maintenir le gain de l'étage.

4. Circuit amplificateur différentiel selon la revendication 1 **caractérisé en ce qu'**un étage cascode ou suiveur est inséré entre ledit premier étage et le second étage de gain de Miller.

5. Circuit amplificateur différentiel selon la revendication 2 **caractérisé en ce que** ledit étage cascode est réalisé au moyen de deux transistors bipolaires de type NPN.

6. Circuit amplificateur différentiel selon la revendication 5 **caractérisé en ce que** ledit étage cascode est réalisé au moyen de deux transistors de type NMOS.

7. Circuit amplificateur selon la revendication 1 **caractérisé en ce qu'**il est adapté à la constitution d'un amplificateur de transmission de données de type A.T.M. ou X.S.D.L.
